# DEMANDE DE BREVET EUROPEEN

(11) **EP 0 679 731 A1**
(43) Date de publication de la demande: **02.11.1995**
(21) Numéro de dépôt: 95400961.9
(22) Date de dépôt: 27.04.1995
(51) Int. Cl.: C23C 14/34, C04B 35/00

(54) **Matériau pour cible de pulverisation cathodique**

(30) Priorité: 28.04.1994 FR 9405176
(71) Demandeur: SAINT GOBAIN VITRAGE INTERNATIONAL, F-92400 Courbevoie (FR)
(72) Inventeur: Nadaud, Nicolas, F-94250 Gentilly (FR); Boch, Philippe, F-72250 Veneux-Les-Sablons (FR); Nannot, Monique, F-75005 Paris (FR)
(74) Mandataire: Breton, Jean-Claude

(57) **Abrégé**

L'invention concerne un matériau pour cible de pulvérisation cathodique. Il s'agit d'ITO fritté densifié.

La porosité inférieure à 2% est obtenue par adjonction d'oxyde de titane.

Application à l'obtention de couches minces conductrices par pulvérisation cathodique.

## Description

L'invenion concerne les techniques de pulvérisation cathodique et plus particulièrement les cibles utilisées dans les installations industrielles de pulvérisation cathodique.

Pour déposer sur un substrat une couche semi-conductrice d'oxyde d'indium-étain en utilisant la pulvérisation cathodique on dispose de deux méthodes. L'une utilise la pulvérisation réactive dans laquelle l'on bombarde avec des ions lourds (Ar) une cible métallique faite d'un alliage d'indium et d'étain en présence d'une atmosphère d'oxygène. Dans l'autre technique, on utilise une cible faite du matériau à déposer lui-même, c'est-à-dire en oxyde d'indium-étain et la pulvérisation n'est pas réactive.

L'invention concerne plus particulièrement cette deuxième technique, elle propose une nouvelle méthode de préparation d'une cible en oxyde d'indium-étain ITO. Les caractéristiques de la cible utilisée pour la pulvérisation jouent un rôle important sur l'efficacité de la pulvérisation ainsi que sur les propriétés des films obtenus. B.L. Gehman et al. dans l'article «Influence of manufacturing process of indium tin oxide sputtering targets on sputtering behavior» Thin Solid Films, 220, 333-336 ( 1992) ont montré que des cibles denses ont un meilleur comportement que celles qui sont poreuses. C'est ainsi qu'elles accroissent la vitesse de dépôt, qu'elles permettent d'obtenir des films dont la résistivité est plus stable et qu'elles évitent ce qu'on appelle des nodules, c'est-à-dire des excroissances qui se développent sur la surface de la cible pendant le bombardement. De tels nodules entrainent une dégradation des performances des couches minces.

Les techniques de fabrication de cibles d'ITO à partir de poudre d'oxyde d'indium associée par frittage à une poudre d'oxyde d'étain sont connues. Ainsi par exemple dans le document J-03 044 465 on décrit une technique où l'on commence par fritter un mélange contenant essentiellement une poudre d'In₂0₃ et de SnO₂ comme composants principaux à une température de 1000 à 1700° C pendant de 1 à 5 heures dans l'air. Puis on effectue ensuite une recuisson sous vide ou sous une atmosphère inerte telle qu'en argon à une température comprise entre 300 et 1700°C pendant une durée de 1 à 10 heures.

Dans un autre document J-04 154 654 on propose de mouler sous pression une poudre qui comprend de l'oxyde d'indium et de l'oxyde d'étain avec une granulométrie inférieure au dixième de micron le frittage est effectué à une température d'au moins 950°C, il est suivi d'un traitement thermique à une température comprise entre 500 et 1300°C en absence d'oxygène.

L'invention propose un matériau à base d'oxyde d'indium-étain fritté destiné à la réalisation de cibles de pulvérisation cathodique, dont la porosité est inférieure à 2 %.

Dans ce matériau la proportion pondérale relative des oxydes d'indium et d'étain s'étend approximativement de 90/10 à 95/5.

Un tel matériau se caractérise en ce qu'il comporte de l'oxyde de titane dans une quantité comprise entre 0,1 et 1 % en poids.

L'invention propose également un procédé de préparation d'un matériau fritté à base d'oxyde d'indium-étain qui comporte les étapes suivantes :
- mélange de poudres d'oxyde d'indium et d'oxyde d'étain, notamment en présence d'éthanol,
- chauffage à plus de 1300°C pendant plus de 2 heures,
- pulvérisation du produit ITO obtenu à une granulométrie au maximum de 5 µm,
- dopage des grains d'ITO par l'oxyde de titane,
- frittage au dessus de 1300°C.

Selon une variante de l'invention, le dopage des grains d'ITO par l'oxyde de titane se fait en deux étapes :
- dissolution d'alcoxyde de titane dans de l'éthanol, création d'une suspension de la poudre dans la solution,
- addition d'eau à la suspension.

De préférence, I'opération de frittage final est précédée par l'addition d'un liant organique, et celui-ci est avantageusement obtenu par dissolution de polyvinylbutyral dans l'éthanol suivie du mélange avec la poudre en suspension.

La description et les figures qui suivent permettront de comprendre le fonctionnement de l'invention et d'en apprécier les avantages.
- la figure 1 résume les étapes de fabrication de l'ITO fritté selon l'invention,
- la figure 2 montre l'évolution de la masse volumique de l'ITO fritté en fonction de la teneur en TiO₂.

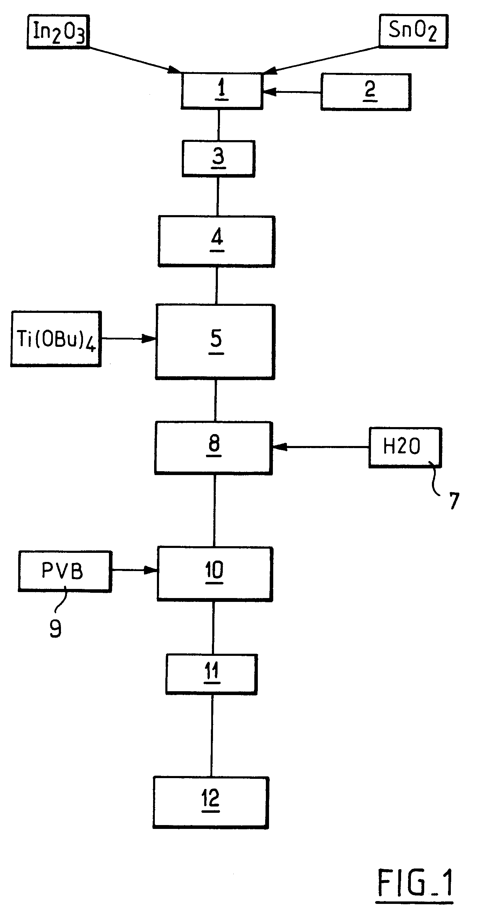

Sur la figure 1 on a représenté les différentes étapes de la préparation d'une cible d'ITO selon l'invention.

Lors des essais, la poudre d'In₂O₃ était une production de Métal Europe Recherche à Trappes en France. Sa pureté était de 99,99 %, le diamètre moyen des grains était compris entre 1 et 2 µm et la masse volumique était de 7,12 g par centimètre cube. La poudre de SnO₂ avait une pureté de 99,9 %, le diamètre des grains était inférieur à 4 µm et la masse volumique de 6,95 grammes par centimètre cube. Les proportions en poids des deux poudres In₂O₃ et SnO₂ étaient 90/10. On commence (opération 1) par mélanger et agiter vigoureusement les deux poudres mélangées. Le mélange s'effectue en présence d'alcool anydre (2). On chauffe ensuite pendant 3 heures le mélange à 1380°C (opération 3). Une mesure en diffraction X effectuée après ce traitement thermique montre qu'on constate déjà la présence des raies caractéristiques de l'ITO et qu'il ne reste plus de manifestation ni de SnO₂ ni de In₂O₃.

L'ITO obtenu à ce stade a alors été réduit en poudre avec une granulométrie inférieure à 2 microns (opération 4). L'oxyde de titane a ensuite été introduit par une réaction de polycondensation hydraulitique de butoxyde de titane, Ti(OBu)₄ (opération 5).

On a dissout l'alcoxyde dans de l'alcool éthylique anydre chaud et on l'a versé dans une boue de poudre d'ITO en suspension dans l'éthanol (opération 6). L'addition d'eau (7) a conduit à la précipitation de TiO₂ à la surface des particules d'ITO (opération 8). On a alors ajouté (opération 10) un liant organique , il s'agissait de polyvinylbutyral (9) dissout à 3 % dans l'éthanol chaud. On a réalisé ensuite (opération 11) des pastilles de 13 mm de diamètre et d'une épaisseur de 1,5 à 2 mm en exerçant une pression uniaxiale de 250 MPa. Le frittage (opération 12) a duré 3 heures, la température était dans le domaine 1350-1400°C.

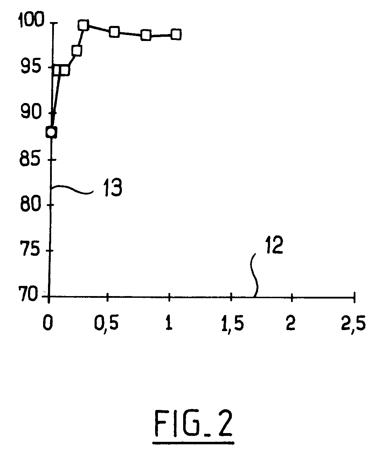

Les essais précédents ont été réalisés avec des taux croissants d'oxyde de titane et , sur la figure 2, on voit l'effet de la teneur en Ti0₂ sur la densification de l'ITO. Sur la figure on voit en abscisses (13), le pourcentage pondéral de TiO₂ et en ordonnées (14), en % la masse volumique de l'ITO obtenu (100 % correspondant à l'ITO massif). Alors que sans TiO₂ la masse volumique de l'ITO fritté ne dépasse pas 88 % elle monte immédiatement jusqu'à une valeur de 100 % pour une teneur en TiO₂ de 0,25 %. Des teneurs plus importantes ne modifient que très peu la densité.

En conclusion on voit que des traitements de frittage de poudre d'ITO en présence de TiO₂ même en quantité très faible permettent d'améliorer très sensiblement la densité de la fritte.

Les essais de pulvérisation cathodique réalisés à partir des cibles d'ITO frittées en présence de TiO₂ ont montré que les couches obtenues avaient des propriétés au moins équivalentes à celles obtenues avec un ITO sans TiO₂ et même supérieures.

La différence réside dans le fait que les cibles possédant une densité supérieure permettent de réaliser la pulvérisation cathodique dans de bien meilleures conditions.

Les avantages sont entre autres : une vitesse de déposition sensiblement accrue et une diminution sensible des arcs qui se produisent pendant la pulvérisation. Cette diminution des arcs est due en particulier à l'absence de nodules sur la face de la cible. Ceux-ci sont courants lorsqu'on utilise un ITO fritté avec une masse volumique réduite. Au contraire, les cibles obtenues avec le matériau fritté de l'invention permettent de travailler à des tensions supérieures sans voir l'apparition de ces nodules ni des arcs qui en sont la conséquence.

Un dernier avantage des cibles préparées grâce au procédé de l'invention réside dans la qualité des couches d'ITO obtenues.

On a en effet constaté que les propriétés électriques et optiques des couches obtenues variaient beaucoup moins au cours d'une campagne de fabrication avec les cibles de l'invention qu'avec de l'ITO fritté traditionnel.

## Revendications

1. Matériau à base d'oxyde d'indium-étain fritté destiné à la réalisation de cibles de pulvérisation cathodique, **caractérisé en ce que** sa porisité est inférieure à 2 %.

2. Matériau selon la revendication 1, **caractérisé en ce que** la proportion pondérale relative des oxydes d'indium et d'étain est comprise approximativement entre 90/10 et 95/5.

3. Matériau selon l'une des revendications précédentes, **caractérisé en ce qu'** il comporte de l'oxyde de titane dans une quantité comprise entre 0,1 et 1 % en poids.

4. Procédé de préparation d'un matériau fritté à base d'oxyde d'indium-étain, **caractérisé en ce qu'**il comporte les étapes suivantes :
- mélange de poudres d'oxyde d'indium et d'oxyde d'étain, notamment en présence d'éthanol,
- chauffage à plus de 1300°C pendant plus de 2 heures,
- pulvérisation du produit ITO obtenu à une granulométrie au maximum de 5 µm,
- dopage des grains d'ITO par l'oxyde de titane,
- frittage au dessus de 1300°C.

5. Procédé selon la revendication 4, **caractérisé en ce que** le dopage des grains d'ITO par l'oxyde de titane se fait en deux étapes :
- dissolution d'alcoxyde de titane dans de l'éthanol, création d'une suspension de la poudre dans la solution,
- addition d'eau à la suspension.

6. Procédé selon la revendication 4 ou 5, **caractérisé en ce que** l'opération de frittage final est précédée par l'addition d'un liant organique.

7. Procédé selon la revendication 6, **caractérisé en ce que** le liant organique est obtenu par dissolution de polyvinylbutyral dans l'éthanol suivie du mélange avec la poudre en suspension.
